# EUROPEAN PATENT SPECIFICATION

(11) **EP 3 039 768 B1**
(45) Date of publication and mention of the grant of the patent: **26.12.2018**
(21) Application number: 14841205.9
(22) Date of filing: 21.08.2014
(51) Int. Cl.: H02J 9/06, H02J 1/10, H05K 7/14

(54) **SHARED BACKUP POWER DATA CENTERS**
DATENZENTREN MIT GEMEINSAMEM RESERVESTROM
CENTRES DE DONNÉES DE PUISSANCE DE SECOURS PARTAGÉS

(30) Priority: 27.08.2013 US 201314010781
(43) Date of publication of application: 06.07.2016
(73) Proprietor: Amazon Technologies, Inc., Reno, NV 89507 (US)
(72) Inventor: TOWNER, Richard, Chadwick, Seattle, WA 98109-5210 (US); CZAMARA, Michael, Phillip, Seattle, WA 98109-5210 (US); MORALES, Osvaldo, P., Seattle, WA 98109-5210 (US); KNIGHT, Kraig, Seattel, WA 98109-5210 (US); RAMIREZ, Antonio, William Vasquez, Seattle, WA 98109-5210 (US)
(74) Representative: Blake, Stephen James
(86) International application number: PCT/US2014/052095
(87) International publication number: WO 2015/031155

(56) References cited:
- WO-A2-2012/074743
- CN-A- 102 842 936
- US-A1- 2005 071 092
- US-A1- 2006 284 489
- US-A1- 2011 320 796
- US-A1- 2012 242 151

## Description

### BACKGROUND

Data centers are facilities used to house and operate computing resources such as computers, processors, servers, telecommunications equipment, data storage systems, and so forth. Data centers may be used to provide services such as large-scale internet applications. Data centers may also be used to provide infrastructure services to customers who may implement their own applications using the resources provided by data centers. Data centers are increasingly critical to various types of computing activities, services, and applications.

The reliability and continuous availability of data center equipment are critically important. Various equipment redundancies are typically implemented within data centers to ensure continuous availability. In particular, redundant power sources are provided to ensure continuous operation during power failures or outages.

Many data centers may include multiple resource zones, each having its own infrastructure and support system. Electrical power for the equipment within a resource zone is provided by an uninterruptable power supply (UPS). The UPS conditions alternating current (AC) power and includes an inverter for generating AC power from associated direct current (DC) batteries.

Normally, the UPS is powered from AC electric mains provided by a power utility. Upon a failure or outage of the AC electric mains, the UPS may temporarily draw DC power from its associated batteries for a short period of time to generate AC power while backup generators are started.
Document WO2012/074743A2 relates to a power distribution system for data center systems, which feeds DC and AC power into first and second AC-DC power supplies of a computer system in the data centre system to provide an uninterruptible supply of power to the computer system. Moreover, in the wording of the claims, WO2012/074743A2 does not discloses a supplemental power storage element located at a separate location external to the plurality of resource zones, and wherein the supplemental power storage element is not collocated with or directly associated with corresponding uninterruptable power supplies; and
does not discloses that the power bus further extends to the supplemental power storage element among the plurality of uninterruptable power supplies.

Document CN102842936A relates to a distributed battery power supply device for supplying power for a data center, wherein the power supply comprises direct current power supply units and battery units arranged on the machine frames and supply power to the server directly. The battery modules are interconnected to communicate with each other via communication circuits.

### BRIEF DESCRIPTION OF THE DRAWINGS

The detailed description is described with reference to the accompanying figures. In the figures, the left-most digit(s) of a reference number identifies the figure in which the reference number first appears. The use of the same reference numbers in different figures indicates similar or identical components or features.
FIG. 1 is a figurative drawing of a data center having multiple resource zones, where each resource zone has a dedicated UPS and associated batteries that are potentially shared between the UPS's.
FIG. 2 is a figurative drawing of a data center having multiple resource zones. Each resource zone has a dedicated UPS and associated batteries. In addition, the data center has an additional set of batteries that are potentially shared between the UPS's of the different resource zones.
FIGS. 3, 4, and 5 are block diagrams illustrating example configurations that may be used within data centers to provide backup power to resource zones of the data centers.
FIG. 6 is a flow diagram illustrating an example method of operating a data center using shared UPS power storage elements.

### DETAILED DESCRIPTION

This disclosure describes systems and techniques for providing backup power to computing resources and other equipment within a data center. The data center has multiple resource zones supported by infrastructures that are generally independent of each other, so that failures relating to one resource zone do not affect the ongoing operations of other resource zones.

The invention is defined by the features of the independent claims 1 and 12. Preferred embodiments are defined in the dependent claims.

Various types of computing resources are located within each of the resource zones. With regard to power distribution, each resource zone has an uninterruptable power supply (UPS) that provides power to the computing resources within the zone. A set of batteries or other energy storage elements are located in the resource zone along with the UPS. Each resource zone may also have a backup generator for providing power during power outages.

The UPS within a particular resource zone normally receives alternating current (AC) power from an electric mains of a power utility. Upon failure of the electric mains, the UPS receives AC power from a backup generator that is dedicated to the resource zone. In the time between failure of the AC mains and startup of the backup generator, the UPS draws direct current (DC) power from its associated batteries and uses an electrical inverter to generate AC power for the equipment of the resource zone.

A power bus may be provided to allow sharing of DC power between the UPS's of different resource zones. The power bus may extend between and/or pass through each of the resource zones, and may be configured to provide a common connection between the DC outputs of the UPS batteries of the different resource zones. The UPS batteries of the different zones may therefore be operated in parallel, to increase the length of time that a particular UPS may operate from DC power. This may be useful in various situations, and may allow battery capacities to be reduced overall and/or within individual resource zones.

In certain embodiments, the power bus may be switched, and control logic may be provided to selectively direct DC power from one resource zone to another based on need. For example, DC power may be directed from a first resource zone to a second resource zone in response to a detected depletion of the batteries of the second resource zone.

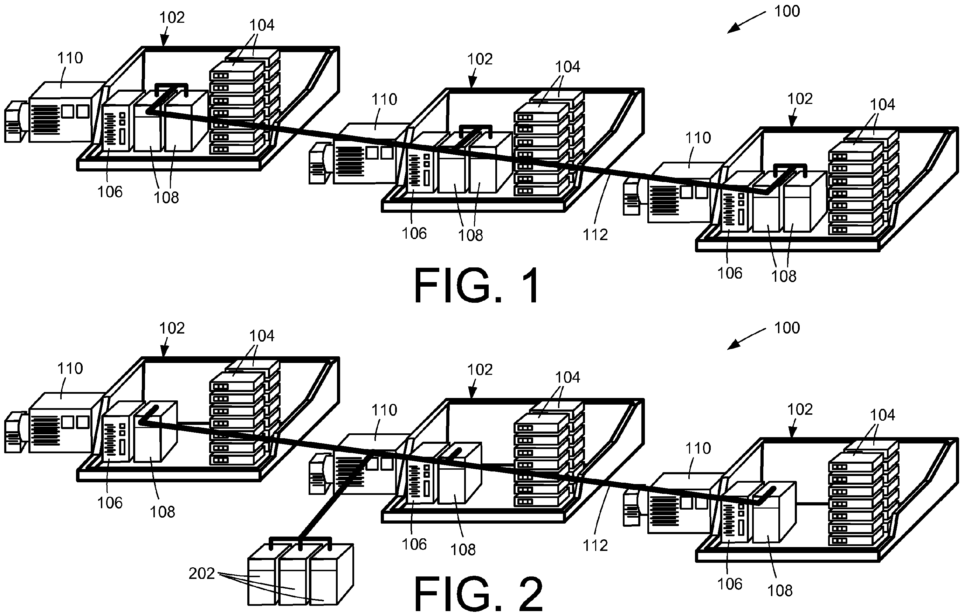

FIG. 1 shows an example of a data center 100 in which the described techniques may be implemented. The data center 100 has a plurality of resource zones 102 in different areas or locations of the data center 100. Each resource zone 102 may, for example, comprise a room of the data center. As another example, each resource zone 102 may comprise a specific area of the data center. In general, each resource zone is supported by an independent local infrastructure, so that a failure relating to one of the resource zones does not affect other resource zones.

Each resource zone 102 has or contains multiple computing resources 104. The resources 104 may include computers, processors, servers, storage devices, networking equipment, telecommunications equipment, control equipment, support equipment, and so forth. The computing resources 104 are typically housed in racks, which are arranged in rows within the data center 100.

Each resource zone 102 has an uninterruptable power supply (UPS) 106 and associated UPS power storage elements 108. The power storage elements 108 may comprise sets of batteries or other power storage mechanisms, including chemical and kinetic power storage devices. For example, each UPS storage element 108 may comprise one or more batteries connected to provide direct current (DC) power to the associated UPS 106. The UPS 106 charges the batteries during normal mains-powered operation, and may draw upon the batteries when conditioning alternating current (AC) mains power or generator-provided AC power. Alternatively, each UPS power storage element or set 108 may comprise a flywheel energy storage unit.

Each resource zone 102 may have its own UPS 106 and corresponding set of storage elements 108, which may be physically located within the resource zone 102.

Each resource zone 102 may also have its own dedicated backup generator 110 or set of backup generators 110 for use during power outages or interruptions. During normal operation, the UPS 106 operates from AC mains provided by an electric power utility. In the case of an AC mains failure, AC power may be provided by the backup generator 110. In the interim between AC mains failure and startup of the backup generator 110, the UPS 106 may generate AC power based on DC power drawn from the storage elements 108 associated with the UPS 106. The UPS 106 may have one or more inverters (not shown) that are used to generate AC power from DC power.

In the described embodiment, a common power bus 112 extends between and into each of the resource zones 102 to provide a common connection between the UPS storage elements 108 of the multiple resource zones 102. The common power bus allows for DC power sharing between the UPS's of the resource zones.

Generally, each of the UPS power storage elements 108 has a power output comprising multiple power terminals, lines, or connections. For example, each set of the storage elements 108 may have a positive terminal, a negative terminal, and a ground terminal. The power bus 112 may have conductors corresponding to each of the multiple terminals, and may be connected in such a way that corresponding terminals of the multiple storage elements 108 are connected in common. Multi-conductor DC power bus bars may be used for this purpose.

The interconnection of the UPS storage elements shown in FIG. 1 may be useful in various situations. As an example, it may happen at the beginning of a power outage that most of the generators start up within an expected startup time, while one of the generators does not start as expected. In a situation like this, the UPS storage elements associated with the resource zones that are receiving backup power from their backup generators may be used to supplement the power of the storage element within the resource zone of the malfunctioning generator. This may allow more time for technicians to troubleshoot and/or manually start the malfunctioning generator.

As another example, it may happen that a bank of UPS storage elements associated with a particular resource zone fails or becomes depleted in an unusually or abnormally short time. In this situation, the UPS storage elements of the other resource zones may be drawn from to supplement or replace the power that would otherwise have been provided by the malfunctioning or depleted storage elements.

As yet another example, it may happen that a UPS associated with a particular resource zone fails. In this situation, the power storage elements of that zone may be used to extend DC power availability to the UPS's of other zones.

Furthermore, it may be possible because of the shared arrangement of UPS power storage elements to reduce the number of storage elements that are located within each of the resource zones. Normally, UPS batteries within a particular zone are sized to accommodate anomalous conditions that are unlikely to occur simultaneously in multiple resource zones. With the arrangement described above, the batteries of different resource zones may be used in combination to supplement an individual zone that is experiencing an unusual or unique condition.

FIG. 2 shows an alternative implementation of the data center 100. In addition to the UPS storage elements 108 that are dedicated to corresponding UPS's 106 and located within the same resource zones 102 as the associated UPS's 106, additional or supplemental power storage elements 202 may be located within the data center 100. The supplemental power storage elements 202 may comprise one or more chemical power storage devices such as battery banks or kinetic energy storage devices such as flywheels that are not collocated with or directly associated with corresponding UPS devices. The supplemental power storage elements 202 may be located within one of the resource zones 102 or at a separate or central location with the data center 100, possibly apart from any UPS units of the data center 100. The common power bus 112 connects the supplemental power storage elements 202 in common with each of the dedicated power storage elements 108.

The supplemental power storage elements 202 may be useful in the scenarios described above, to supplement the power provided by the dedicated power storage elements 108. In certain implementations, the availability of the supplemental storage elements 202 may make it possible to reduce the number or capacity of the dedicated power storage elements 108 that are located in each of the resource zones 102. For example, the dedicated power storage elements 108 may be sized to accommodate normal or expected failure sequences, such as might be based on an assumption that the backup generators 110 will be started within an expected time after the beginning of an AC mains power failure. In the case that one or more of the backup generators 110 does not start as expected, the supplemental storage elements 202 may be used to provide additional DC power for the UPS 106 of the resource zone 102 where the backup generator 110 has failed to start.

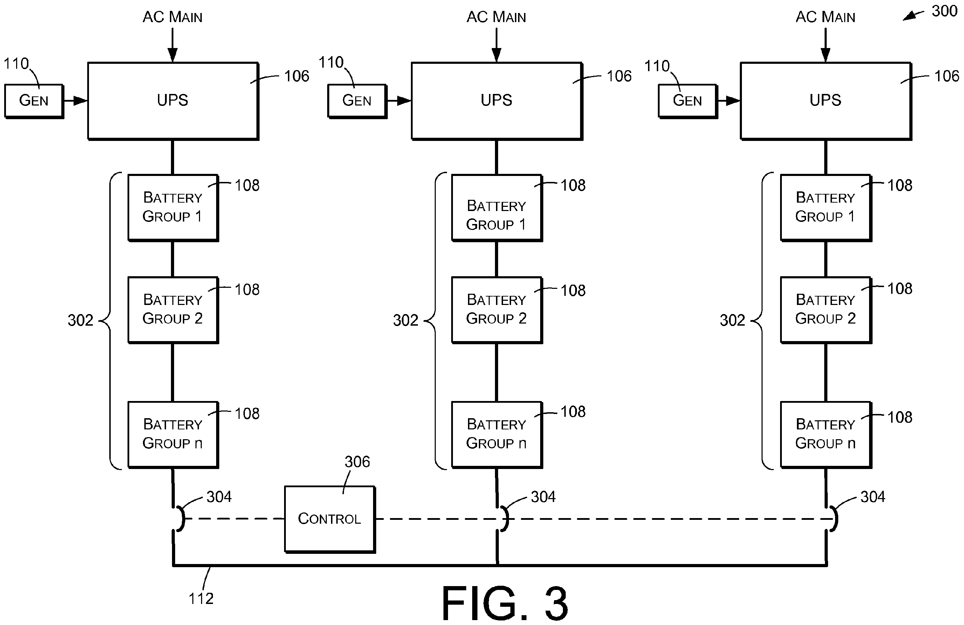

FIG. 3 shows further details regarding an implementation of a data center backup power system 300. The system 300 includes a plurality of UPS's 106 as described above. Each UPS 106 is associated with and dedicated to a particular resource zone, and may be located at or within the resource zone. Each UPS 106 provides conditioned power and backup power to the computing resources within the associated resource zone.

Each UPS 106 normally receives AC power from a power utility mains. In addition, a backup generator 110 is associated with and/or dedicated to each of the resource zones and the UPS's 106 of the resource zones. Upon failure or outage of the AC power mains, the generator 110 automatically starts within a period of time such as 45-120 seconds. During the interim between AC power mains failure and startup of the generator 110, each UPS 106 draws power from one or more associated or dedicated power storage elements 108, which in this example are illustrated as battery sets, groups, or banks. Each battery set may comprise one or more batteries or battery elements. Although FIG. 3 is illustrated as being implemented with chemical-based battery sets, other implementations may use other types of storage elements in place of the battery sets. For example, kinetic energy storage devices may be used in place of the battery sets in certain embodiments.

In the embodiment of FIG. 3, each UPS 106 has a set 302 of power storage elements, which may comprise a number n of individual storage elements 108. Each set 302 of power storage elements is located at or within its associated resource zone. Each set 302 of storage elements 108 is connected through power switches 304 with the common power bus 112. The common power bus 112 extends into each of the resource zones to connect between the storage elements 108 of the different resource zones.

Control logic 306 may be provided to selectively direct and/or connect DC power from the storage element set 302 of one or more of the resource zones to the storage elements and/or UPS's 106 of one or more others of the resource zones. In some cases, the control logic 306 may monitor the power levels of the storage element sets 302. In response to detecting depletion of power in one of the storage element sets 302, the control logic 306 may direct or connect power to the depleted storage element set 302 and its associated UPS 106 from another of the storage element sets 302. This may happen, for example, when the backup generator 110 associated with a particular UPS 106 fails to start as expected, and additional DC power is needed to sustain the UPS 106 while the backup generator 110 is started manually.

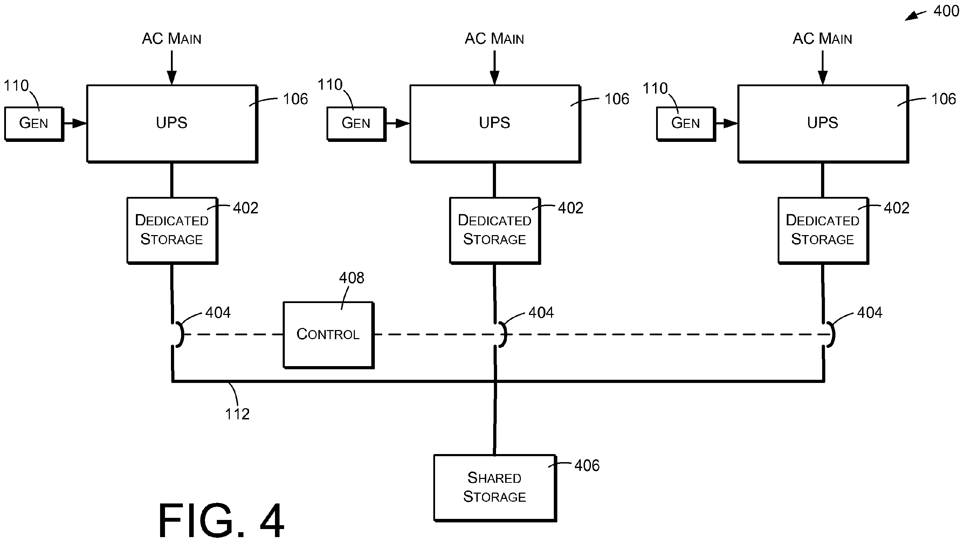

FIG. 4 shows details regarding another implementation of a data center backup power system 400. The system 400 includes a plurality of UPS's 106 as described above. Each UPS 106 is associated with and dedicated to a particular resource zone, and may be located at or within the resource zone. Each UPS 106 provides conditioned power and backup power to the computing resources within the associated resource zone.

Each UPS 106 normally receives AC power from a power utility mains. In addition, a generator 110 is associated with and/or dedicated to each of the resource zones and the UPS's 106 of the resource zones. Upon failure or outage of the AC power mains, the generator 110 automatically starts within a period of time such as 45-120 seconds. During the interim between AC power mains failure and startup of the generator 110, each UPS 106 draws power from one or more associated and dedicated power storage elements 402. Each storage element may comprise one or more batteries, one or more kinetic energy storage devices, other types of energy storage devices, or sets of energy storage devices. For example, a single flywheel-based energy storage device may be associated with each of the UPS's 106, in each of the resource zones. Each dedicated storage element 402 is located at or within its associated resource zone.

Each of the dedicated storage elements 402 is connected through power switches 404 with the common power bus 112. The common power bus 112 extends into each of the resource zones to connect between the storage elements 402 of the different resource zones.

In addition to the dedicated storage elements 402, which are collocated and associated directly with respective UPS units, the system 400 may include one or more shared or supplemental storage elements 406, which may comprise one or more batteries, one or more kinetic energy storage devices, other types of energy storage devices, or sets of energy storage devices.

Control logic 408 may be provided to selectively direct and/or connect DC power from the supplemental storage elements 406 to one or more of the dedicated storage elements 402 and/or UPS's 106. In some cases, the control logic 408 may monitor the power levels of the storage elements 402. In response to detecting depletion of power in one of the dedicated storage elements 402, the control logic 408 may direct power to the depleted storage element 402 and its associated UPS 106 from the supplemental storage elements 406. This may happen, for example, when the backup generator 110 associated with a particular UPS 106 fails to start as expected, and additional DC power is needed to sustain the UPS 106 while the backup generator 110 is started manually.

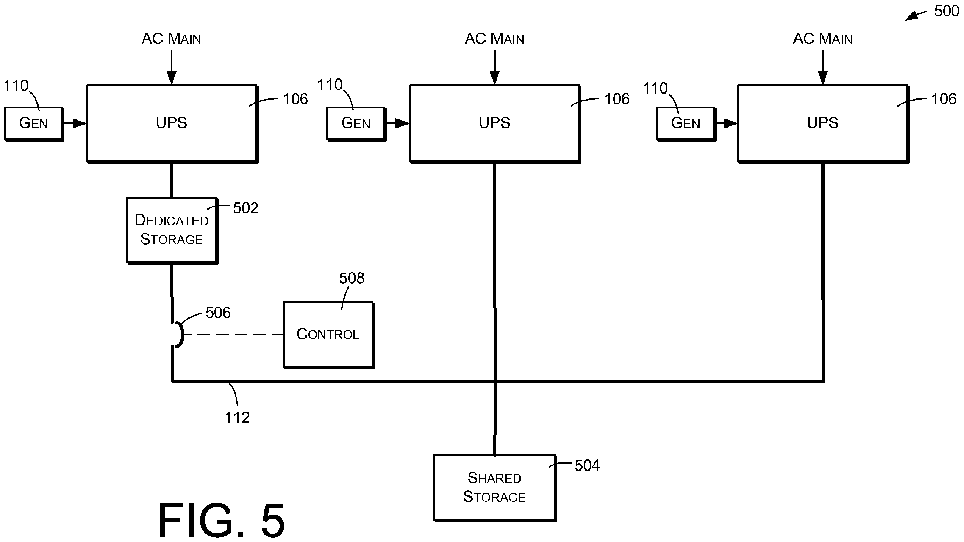

FIG. 5 shows details regarding another implementation of a data center backup power system 500. The system 500 includes a plurality of UPS's 106 as described above. Each UPS 106 is associated with and dedicated to a particular resource zone, and may be located at or within the resource zone. Each UPS 106 provides conditioned power and backup power to the computing resources within the associated resource zone.

Each UPS 106 normally receives AC power from a power utility mains. In addition, a generator 110 is associated with and/or dedicated to each of the resource zones and the UPS's 106 of the resource zones. Upon failure or outage of the AC power mains, the generator 110 automatically starts within a period of time such as 45-120 seconds. During the interim between AC power mains failure and startup of the generator 110, each UPS 106 draws power from one or more power storage elements.

In the example of FIG. 5, the power storage elements may include one or more dedicated power storage elements 502 and one or more shared power storage elements 504. Each dedicated power storage element 502 is associated with and located at or within a corresponding resource zone to provide temporary operating power to the UPS 106 associated with that zone. The shared power storage element 504 may be commonly located, such as at a central location within the data center or at any other location. The power bus 112 extends from the shared power storage element 504 to each of the resource zones.

Some of the resource zones and their UPS's 106 may not be associated with dedicated power storage elements. In this example, two of the UPS's 106 do not have dedicated or directly associated power storage elements 502. Rather, these UPS's 106 are connected by the power bus 112 to receive temporary power directly from the shared power storage element 504.

Each of the storage element 502 and 504 may comprise one or more batteries, one or more kinetic energy storage devices, other types of energy storage devices, or sets of energy storage devices.

The dedicated storage element 502 may be connected through a power switch 506 with the common power bus 112. Control logic 508 may be provided to selectively direct and/or connect DC power from the shared power storage element 504 to the dedicated storage element 502 and/or UPS's 106. In some cases, the control logic 508 may monitor the power levels of the dedicated storage element 502. In response to detecting depletion of power in the dedicated storage element 502, the control logic 508 may direct power to the depleted storage element 502 and its associated UPS 106 from the shared storage element 504.

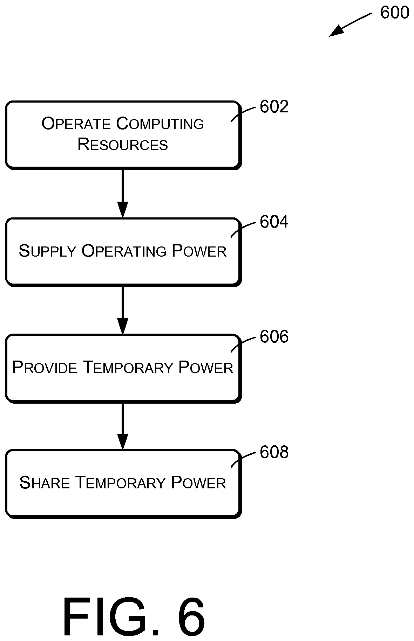

FIG. 6 illustrates an example method 600 of operating a data center in accordance with the techniques described above. An action 602 comprises operating a plurality of computing resources within different resource zones of a data center. The resource zones may in some cases comprise physically different areas or rooms of the data center, and may be locally supported by independent infrastructures.

An action 604 comprises supplying operating power to the computing resources from UPS's located respectively in the different resource zones. The UPS's may be configured to receive AC power from an AC power mains and/or from an AC generator. The generator may be used to supply AC power upon failure of the AC power mains.

An action 606 comprises providing temporary power to the UPSs from a plurality of power storage elements, including one or more power storage elements located in each of the different resource zones. This may be performed during initial stages of a power outage, before backup generators have been started.

An action 608 comprises sharing the temporary power from the power storage elements located in the different resource zones among the UPS's located in the different resource zones. In some embodiments, this may be accomplished by use a power bus that extends between the power storage elements. In some cases, the action 608 may comprise selectively directing the temporary power provided by a first of the power storage elements to the uninterruptable power supply associated with a second of the power storage elements in response to power depletion of the second of the power storage elements.

Although the subject matter has been described in language specific to structural features, it is to be understood that the subject matter defined in the appended claims is not necessarily limited to the specific features described. Rather, the specific features are disclosed as illustrative forms of implementing the claims.

## Claims

1. A data center (100), comprising:
a plurality of resource zones (102);
computing resources (104) located within each of the resource zones (102);
a plurality of uninterruptable power supplies (106) which can be powered by an AC mains power source, and which can temporarily draw power from a DC power source upon failure of the AC mains power source, and each uninterruptable power supply (106) comprising a power storage element (108) that provides temporary power to the uninterruptable power supply (106), wherein each uninterruptable power supply (106) is associated with an individual one of the resource zones (102), and wherein each uninterruptable power supply (106) is configured to provide operating power to the computing resources (104) located within the associated resource zone (102); and
a power bus (112) that extends to each of the resource zones (102) for sharing the temporary power provided by the power storage elements (108) among the plurality of_uninterruptable power supplies (106);
**characterised in that** that the data center further comprising
a supplemental power storage element (202) located at a separate location external to the plurality of resource zones (102), and
wherein the supplemental power storage element (202) is not collocated with or directly associated with corresponding uninterruptable power supplies (106); and
the power bus (112) that extends to each of the resource zones (102) for sharing the temporary power provided by the power storage elements (108)
further extends to the supplemental power storage element (202) among the plurality of uninterruptable power supplies (106).

2. The data center (100) of claim 1, further comprising control logic (306) configured to selectively direct the temporary power among the uninterruptible power supplies (106) in response to power depletion of the power storage elements (108).

3. The data center (100) of any preceding claim, wherein:
the power storage elements (108) comprise a plurality of power storage elements (108) that are commonly located; and
the power bus (112) extends from the plurality of uninterruptable power supplies (10) to each of the resource zones (102).

4. The data center (100) of any preceding claim, wherein:
a particular one of the uninterruptable power supplies (106) is associated with a first of the power storage elements (108); and
further comprising control logic (306) configured to selectively direct the temporary power provided by a second of the power storage elements (108) to said particular one of the uninterruptable power supplies (106) in response to power depletion or detected malfunction of said first of the power storage elements (108).

5. The data center (100) of any of claims 1-3, wherein:
a first of the uninterruptable power supplies (106) is associated with a first of the power storage elements (108);
a second of the uninterruptable power supplies (106) is associated with a second of the power storage elements (108); and
further comprising control logic (306) configured to selectively direct the temporary power provided by the second of the power storage elements (108) to the first of the uninterruptable power supplies (106) in response to power depletion of said first of the power storage elements (108).

6. The data center (100) of claim 5, wherein:
the control logic (306) selectively directs the temporary power provided by the second of the power storage elements (108) to the first of the uninterruptable power supplies (10) in response to a detected malfunction of said first of the power storage elements(108).

7. The data center (100) of any preceding claim, further comprising a plurality of backup generators (110), wherein the power storage elements (108) are configured to provide the temporary power during startup of the backup generators (110).

8. The data center (100) of any preceding claim, wherein the power storage elements (108) comprise:
a plurality of dedicated power storage elements (108, 402) associated respectively with individual uninterruptable power supplies (106), wherein each dedicated power storage element (108, 402) provides temporary power to the associated uninterruptable power supply (106);
a supplemental power storage element (202, 406) that provides supplemental power; and
wherein the power bus (112) connects the supplemental power storage element (202) to the dedicated power storage elements (108) to supplement the temporary power of the dedicated power storage elements (108).

9. The data center (100) of claim 8, further comprising control logic (408) that selectively directs the temporary power provided by the supplemental power storage element (202, 406) to the uninterruptable power supply (106) associated with one of the dedicated power storage elements (108, 402) in response to power depletion of said one of the dedicated power storage elements (108, 402).

10. The data center (100) of any preceding claim, wherein the power storage elements (108) comprise:
a plurality of dedicated battery sets (108, 402) associated respectively with individual uninterruptable power supplies (106), wherein each dedicated battery (108, 402) set provides temporary power to the associated uninterruptable power supply (106);
a supplemental battery set (202, 406) that provides supplemental power; and
wherein the power bus (112) connects the supplemental battery set (202, 406) to the dedicated battery sets (108, 402) to supplement the temporary power of the dedicated battery sets (108, 402).

11. The data center (100) of any preceding claim, wherein the power storage elements (108) comprise:
a plurality of kinetic energy storage devices associated respectively with individual uninterruptable power supplies, wherein each kinetic energy storage device provides temporary power to the associated uninterruptable power supply (106);
one or more batteries that provide supplemental power; and
wherein the power bus (112) connects the one or more batteries to the uninterruptible power supplies (106) associated with the kinetic energy storage devices to supplement the temporary power of the one or more kinetic energy storage devices.

12. A method, comprising:
operating computing resources (104) within resource zones (102) of a data center (100);
supplying operating power to the computing resources (104) from uninterruptable power supplies (106) associated respectively with the resource zones (102), wherein an AC mains power source powers the uninterruptable power supplies (106), and wherein a DC power source temporarily provides power upon failure of the AC mains power source;
providing temporary power to an uninterruptable power supply (106) of the uninterruptable power supplies (106) from a first power storage element (108) of one or more power storage elements (108), the first power storage element being a part of the uninterruptable power supply (106);
providing additional temporary power to the uninterruptible power supply (106) from a supplemental power storage element (202) located at a separate location external to the resource zones (102), wherein the supplemental power storage element (202) is not collocated with or directly associated with corresponding uninterruptible power supplies (106); and
sharing additional temporary power with the uninterruptable power supply (106) from a second power storage element (108) of the one or more power storage elements (108), the second power storage element not being a part of the uninterruptable power supply (106).

13. The method of claim 12, wherein the one or more power storage elements (108) include at least one power storage element (108) that is located at a corresponding one of the resource zones (102), or wherein the one or more power storage elements (108) include at least one power storage element (108) located at each of the resource zones (102), or wherein the one or more power storage elements (108) include at least one kinetic energy storage device that is associated with each of the resource zones (102) and at least one chemical power storage device that is associated with a plurality of the resource zones (102).

14. The method of claim 12 or 13, wherein:
sharing the additional temporary power comprises selectively directing the temporary power provided by the second power storage element (108) to the uninterruptable power supply (106) in response to power depletion of said first power storage element (108).

15. The method of any of claims 12-14, wherein:
sharing the additional temporary power comprises selectively directing the temporary power provided by the second power storage element (108) to the uninterruptable power supply (106) in response to a detected malfunction of said first power storage element (108).

## Patentansprüche

1. Rechenzentrum (100), umfassend:
eine Vielzahl von Ressourcenzonen (102);
Rechenressourcen (104), die in jeder der Ressourcenzonen (102) angeordnet sind;
eine Vielzahl von unterbrechungsfreien Stromversorgungen (106), die von einer Wechselstromnetzquelle gespeist werden können und die bei Ausfall der Wechselstromnetzquelle vorübergehend Leistung von einer Gleichstromquelle beziehen können, und wobei jede unterbrechungsfreie Stromversorgung (106) ein Energiespeicherelement (108) umfasst, das die unterbrechungsfreie Stromversorgung (106) vorübergehend mit Strom versorgt, wobei jede unterbrechungsfreie Stromversorgung (106) mit einer einzelnen der Ressourcenzonen (102) assoziiert ist, und wobei jede unterbrechungsfreie Stromversorgung (106) konfiguriert ist, um die Rechenressourcen (104), die in der assoziierten Ressourcenzone (102) angeordnet sind, mit Betriebsleistung zu versorgen;
und
einen Leistungsbus (112), der sich zu jeder der Ressourcenzonen (102) erstreckt, um die von den Energiespeicherelementen (108) bereitgestellte vorübergehende Leistung unter der Vielzahl von unterbrechungsfreien Stromversorgungen (106) zu teilen;
**dadurch gekennzeichnet, dass** das Rechenzentrum ferner Folgendes umfasst:
ein zusätzliches Energiespeicherelement (202), das an einem separaten Ort außerhalb der Vielzahl von Ressourcenzonen (102) angeordnet ist, und wobei das zusätzliche Energiespeicherelement (202) nicht am selben Standort wie entsprechende unterbrechungsfreie Stromversorgungen (106) angeordnet ist oder direkt mit diesen assoziiert ist; und
wobei der Leistungsbus (112), der sich zu jeder der Ressourcenzonen (102) erstreckt, um die von den Energiespeicherelementen (108) bereitgestellte vorübergehende Leistung zu teilen, sich weiter zu dem zusätzlichen Energiespeicherelement (202) unter der Vielzahl von unterbrechbaren Leistungsversorgungen (106) erstreckt.

2. Rechenzentrum (100) nach Anspruch 1, ferner umfassend eine Steuerlogik (306), die konfiguriert ist, um als Reaktion auf eine Energieverringerung der Energiespeicherelemente (108) selektiv die vorübergehende Leistung unter den unterbrechungsfreien Stromversorgungen (106) zu leiten.

3. Rechenzentrum (100) nach einem der vorhergehenden Ansprüche, wobei:
die Energiespeicherelemente (108) eine Vielzahl von Energiespeicherelementen (108) umfassen, die gemeinsam angeordnet sind; und
der Leistungsbus (112) sich von der Vielzahl von unterbrechungsfreien Stromversorgungen (10) zu jeder der Ressourcenzonen (102) erstreckt.

4. Rechenzentrum (100) nach einem der vorhergehenden Ansprüche, wobei:
eine bestimmte der unterbrechungsfreien Stromversorgungen (106) mit einem ersten der Energiespeicherelemente (108) assoziiert ist; und
ferner umfassend eine Steuerlogik (306), die konfiguriert ist, um als Reaktion auf eine Energieverringerung oder eine erkannte Fehlfunktion des ersten der Energiespeicherelemente (108) die von einem zweiten der Energiespeicherelemente (108) gelieferte vorübergehende Leistung selektiv zu der bestimmten der unterbrechungsfreien Stromversorgungen (106) zu leiten.

5. Rechenzentrum (100) nach einem der Ansprüche 1-3, wobei:
eine erste der unterbrechungsfreien Stromversorgungen (106) mit einem ersten der Energiespeicherelemente (108) assoziiert ist;
eine zweite der unterbrechungsfreien Stromversorgungen (106) mit einem zweiten der Energiespeicherelemente (108) assoziiert ist; und
ferner umfassend eine Steuerlogik (306), die konfiguriert ist, um als Reaktion auf eine Energieverringerung des ersten der Energiespeicherelemente (108) die von dem zweiten der Energiespeicherelemente (108) gelieferte vorübergehende Leistung selektiv zu der ersten der unterbrechungsfreien Stromversorgungen (106) zu leiten.

6. Rechenzentrum (100) nach Anspruch 5, wobei:
die Steuerlogik (306) als Reaktion auf eine erkannte Fehlfunktion des ersten der Energiespeicherelemente (108) die von dem zweiten der Energiespeicherelemente (108) gelieferte vorübergehende Leistung selektiv zu der ersten der unterbrechungsfreien Stromversorgungen (10) leitet.

7. Rechenzentrum (100) nach einem der vorhergehenden Ansprüche, ferner umfassend eine Vielzahl von Sicherungsgeneratoren (110), wobei die Energiespeicherelemente (108) konfiguriert sind, die vorübergehende Leistung während des Starts der Sicherungsgeneratoren (110) bereitzustellen.

8. Rechenzentrum (100) nach einem der vorhergehenden Ansprüche, wobei die Energiespeicherelemente (108) Folgendes umfassen:
eine Vielzahl dedizierter Energiespeicherelemente (108, 402), die jeweils mit einzelnen unterbrechungsfreien Stromversorgungen (106) assoziiert sind, wobei jedes dedizierte Energiespeicherelement (108, 402) der assoziierten unterbrechungsfreien Stromversorgung (106) vorübergehende Leistung bereitstellt;
ein zusätzliches Energiespeicherelement (202, 406), das zusätzliche Leistung bereitstellt; und
wobei der Leistungsbus (112) das zusätzliche Energiespeicherelement (202) mit den dedizierten Energiespeicherelementen (108) verbindet, um die vorübergehende Leistung der dedizierten Energiespeicherelemente (108) zu ergänzen.

9. Rechenzentrum (100) nach Anspruch 8, ferner umfassend eine Steuerlogik (408), die als Reaktion auf eine Energieverringerung des ersten der dedizierten Energiespeicherelemente (108, 402) die von dem zusätzlichen Energiespeicherelement (202, 406) bereitgestellte vorübergehende Leistung selektiv zu der unterbrechungsfreien Stromversorgung (106) leitet, die mit einem der dedizierten Energiespeicherelemente (108, 402) assoziiert ist.

10. Rechenzentrum (100) nach einem der vorhergehenden Ansprüche, wobei die Energiespeicherelemente (108) Folgendes umfassen:
eine Vielzahl dedizierter Batteriesätze (108, 402), die jeweils mit einzelnen unterbrechungsfreien Stromversorgungen (106) assoziiert sind, wobei jeder dedizierte Batteriesatz (108, 402) der assoziierten unterbrechungsfreien Stromversorgung (106) vorübergehende Leistung bereitstellt;
einen zusätzliches Batteriesatz (202, 406), der zusätzliche Leistung bereitstellt; und
wobei der Leistungsbus (112) den zusätzliche Batteriesatz (202, 406) mit den dedizierten Batteriesätzen (108, 402) verbindet, um die vorübergehende Leistung der dedizierten Batteriesätze (108, 402) zu ergänzen.

11. Rechenzentrum (100) nach einem der vorhergehenden Ansprüche, wobei die Energiespeicherelemente (108) Folgendes umfassen:
eine Vielzahl kinetischer Energiespeichervorrichtungen, die jeweils mit einzelnen unterbrechungsfreien Stromversorgungen assoziiert sind, wobei jede kinetische Energiespeichervorrichtung der assoziierten unterbrechungsfreien Stromversorgung (106) vorübergehende Leistung bereitstellt;
eine oder mehrere Batterien, die zusätzliche Leistung bereitstellen; und
wobei der Leistungsbus (112) die eine oder die mehreren Batterien mit den unterbrechungsfreien Stromversorgungen (106) verbindet, die mit den kinetischen Energiespeichervorrichtungen assoziiert sind, um die vorübergehende Leistung der einen oder mehreren kinetischen Energiespeichervorrichtungen zu ergänzen.

12. Verfahren, umfassend:
Betreiben von Rechenressourcen (104) innerhalb von Ressourcenzonen (102) eines Rechenzentrums (100);
Zuführen von Betriebsleistung zu den Rechenressourcen (104) von unterbrechungsfreien Stromversorgungen (106), die jeweils mit den Ressourcenzonen (102) assoziiert sind, wobei eine Wechselstromnetzquelle die unterbrechungsfreien Stromversorgungen (106) mit Leistung versorgt und wobei eine Gleichstromquelle bei Ausfall der Wechselstromnetzquelle vorübergehend Leistung bereitstellt;
Bereitstellen von vorübergehender Leistung an eine unterbrechungsfreie Stromversorgung (106) der unterbrechungsfreien Stromversorgungen (106) von einem ersten Energiespeicherelement (108) eines oder mehrerer Energiespeicherelemente (108), wobei das erste Energiespeicherelement ein Teil der unterbrechungsfreien Stromversorgung (106) ist;
Bereitstellen zusätzlicher vorübergehender Leistung an die unterbrechungsfreie Stromversorgung (106) von einem zusätzlichen Energiespeicherelement (202), das an einem separaten Ort außerhalb der Ressourcenzonen (102) angeordnet ist, wobei das zusätzliche Energiespeicherelement (202) nicht am selben Standort wie entsprechende unterbrechungsfreie Stromversorgungen (106) angeordnet ist oder direkt mit diesen assoziiert ist; und
Teilen zusätzlicher vorübergehender Leistung mit der unterbrechungsfreien Stromversorgung (106) von einem zweiten Energiespeicherelement (108) des einen oder der mehreren Energiespeicherelemente (108), wobei das zweite Energiespeicherelement nicht Teil der unterbrechungsfreien Stromversorgung (106) ist.

13. Verfahren nach Anspruch 12, wobei das eine oder die mehreren Energiespeicherelemente (108) mindestens ein Energiespeicherelement (108) umfassen, das an einer entsprechenden der Ressourcenzonen (102) angeordnet ist, oder wobei das eine oder die mehreren Energiespeicherelemente (108) mindestens ein Energiespeicherelement (108) einschließen, das in jeder der Ressourcenzonen (102) angeordnet ist, oder wobei das eine oder die mehreren Energiespeicherelemente (108) mindestens eine kinetische Energiespeichervorrichtung, die mit jeder der Ressourcenzonen (102) assoziiert ist, und mindestens eine chemische Energiespeichervorrichtung, die mit einer Vielzahl der Ressourcenzonen (102) assoziiert ist, einschließen.

14. Verfahren nach Anspruch 12 oder 13, wobei
das Teilen der zusätzlichen vorübergehenden Leistung das selektive Leiten der von dem zweite Energiespeicherelement (108) bereitgestellten vorübergehenden Leistung zu der unterbrechungsfreien Stromversorgung (106) als Reaktion auf eine Energieverringerung des ersten Energiespeicherelements (108) umfasst.

15. Verfahren nach einem der Ansprüche 12-14, wobei:
das Teilen der zusätzlichen vorübergehenden Leistung das selektive Leiten der von dem zweiten Energiespeicherelement (108) bereitgestellten vorübergehenden Leistung zu der unterbrechungsfreien Stromversorgung (106) als Reaktion auf eine erkannte Fehlfunktion des ersten Energiespeicherelements (108) umfasst.

## Revendications

1. Centre de données (100), comprenant :
une pluralité de zones de ressources (102) ;
des ressources informatiques (104) qui sont situées dans chacune des zones de ressources (102) ;
une pluralité de systèmes d'alimentation sans coupure (106), qui peuvent être alimentés par une source d'alimentation secteur en courant alternatif, et qui peuvent puiser temporairement de l'énergie à partir d'une source d'alimentation en courant continu suite à une défaillance de la source d'alimentation secteur en courant alternatif, et dans lequel chaque système d'alimentation sans coupure (106) comprend un élément de stockage d'énergie (108) qui fournit une puissance temporaire au système d'alimentation sans coupure (106), dans lequel chaque système d'alimentation sans coupure (106) est associé à une zone individuelle parmi les zones de ressources (102), et dans lequel chaque système d'alimentation sans coupure (106) est configuré de manière à fournir une puissance de fonctionnement aux ressources informatiques (104) situées dans la zone de ressources associée (102) ; et
un bus d'alimentation (112) qui s'étend jusqu'à chacune des zones de ressources (102) pour partager la puissance temporaire fournie par les éléments de stockage d'énergie (108) entre la pluralité de systèmes d'alimentation sans coupure (106) ;
**caractérisé en ce que** le centre de données comprend en outre un élément de stockage d'énergie supplémentaire (202) situé au niveau d'un emplacement distinct externe à la pluralité de zones de ressources (102) ; et
dans lequel l'élément de stockage d'énergie supplémentaire (202) n'est pas colocalisé avec des systèmes d'alimentation sans coupure correspondants, ni directement associé à des systèmes d'alimentation sans coupure correspondants (106) ; et
le bus d'alimentation (112) qui s'étend jusqu'à chacune des zones de ressources (102) pour partager la puissance temporaire fournie par les éléments de stockage d'énergie (108) s'étend en outre jusqu'à l'élément de stockage d'énergie supplémentaire (202) parmi la pluralité de systèmes d'alimentation sans coupure (106).

2. Centre de données (100) selon la revendication 1, comprenant en outre une logique de commande (306) configurée de manière à diriger sélectivement la puissance temporaire entre les systèmes d'alimentation sans coupure (106) en réponse à une diminution de puissance des éléments de stockage d'énergie (108).

3. Centre de données (100) selon l'une quelconque des revendications précédentes, dans lequel :
les éléments de stockage d'énergie (108) comprennent une pluralité d'éléments de stockage d'énergie (108) qui sont colocalisés ; et
le bus d'alimentation (112) s'étend de la pluralité de systèmes d'alimentation sans coupure (10) jusqu'à chacune des zones de ressources (102).

4. Centre de données (100) selon l'une quelconque des revendications précédentes, dans lequel :
un système d'alimentation sans coupure spécifique des systèmes d'alimentation sans coupure spécifique (106) est associé à un premier élément des éléments de stockage d'énergie (108) ; et
comprenant en outre une logique de commande (306) configurée de manière à diriger sélectivement la puissance temporaire fournie par un second élément des éléments de stockage d'énergie (108) vers ledit système spécifique des systèmes d'alimentation sans coupure (106) en réponse à une diminution de puissance ou à un dysfonctionnement détecté dudit premier élément des éléments de stockage d'énergie (108).

5. Centre de données (100) selon l'une quelconque des revendications 1 à 3, dans lequel :
un premier système des systèmes d'alimentation sans coupure (106) est associé à un premier élément des éléments de stockage d'énergie (108) ;
un second système des systèmes d'alimentation sans coupure (106) est associé à un second élément des éléments de stockage d'énergie (108) ; et
comprenant en outre une logique de commande (306) configurée de manière à diriger sélectivement la puissance temporaire fournie par le second élément des éléments de stockage d'énergie (108) vers le premier système des systèmes d'alimentation sans coupure (106), en réponse à une diminution de puissance dudit premier élément des éléments de stockage d'énergie (108).

6. Centre de données (100) selon la revendication 5, dans lequel :
la logique de commande (306) dirige sélectivement la puissance temporaire fournie par le second élément des éléments de stockage d'énergie (108) vers le premier système des systèmes d'alimentation sans coupure (10) en réponse à un dysfonctionnement détecté dudit premier élément des éléments de stockage d'énergie (108).

7. Centre de données (100) selon l'une quelconque des revendications précédentes, comprenant en outre une pluralité de générateurs de secours (110), dans lequel les éléments de stockage d'énergie (108) sont configurés de manière à fournir la puissance temporaire au cours du démarrage des générateurs de secours (110).

8. Centre de données (100) selon l'une quelconque des revendications précédentes, dans lequel les éléments de stockage d'énergie (108) comprennent :
une pluralité d'éléments de stockage d'énergie dédiés (108, 402) associés respectivement à des systèmes d'alimentation sans coupure individuels (106), dans lequel chaque élément de stockage d'énergie dédié (108, 402) fournit une puissance temporaire au système d'alimentation sans coupure associé (106) ;
un élément de stockage d'énergie supplémentaire (202, 406) qui fournit une puissance supplémentaire ; et
dans lequel le bus d'alimentation (112) connecte l'élément de stockage d'énergie supplémentaire (202) aux éléments de stockage d'énergie dédiés (108) pour compléter la puissance temporaire des éléments de stockage d'énergie dédiés (108).

9. Centre de données (100) selon la revendication 8, comprenant en outre une logique de commande (408) qui dirige sélectivement la puissance temporaire fournie par l'élément de stockage d'énergie supplémentaire (202, 406) vers le système d'alimentation sans coupure (106) associé à l'un des éléments de stockage d'énergie dédiés (108, 402) en réponse à une diminution de puissance dudit un élément des éléments de stockage d'énergie dédié (108, 402).

10. Centre de données (100) selon l'une quelconque des revendications précédentes, dans lequel les éléments de stockage d'énergie (108) comprennent :
une pluralité de blocs-batteries dédiés (108, 402) associés respectivement à des systèmes d'alimentation sans coupure individuels (106), dans lequel chaque bloc-batteries dédié (108, 402) fournit une puissance temporaire au système d'alimentation sans coupure associé (106) ;
un bloc-batteries supplémentaire (202, 406) qui fournit une puissance supplémentaire ; et
dans lequel le bus d'alimentation (112) connecte le bloc-batteries supplémentaire (202, 406) aux blocs-batteries dédiés (108, 402) en vue de compléter la puissance temporaire des blocs-batteries dédiés (108, 402).

11. Centre de données (100) selon l'une quelconque des revendications précédentes, dans lequel les éléments de stockage d'énergie (108) comprennent :
une pluralité de dispositifs de stockage d'énergie cinétique associés respectivement à des systèmes d'alimentation sans coupure individuels, dans lequel chaque dispositif de stockage d'énergie cinétique fournit une puissance temporaire au système d'alimentation sans coupure associé (106) ;
une ou plusieurs batteries qui fournissent une puissance supplémentaire ; et
dans lequel le bus d'alimentation (112) connecte ladite une ou lesdites plusieurs batteries aux systèmes d'alimentation sans coupure (106) associés aux dispositifs de stockage d'énergie cinétique en vue de compléter la puissance temporaire dudit un ou desdits plusieurs dispositifs de stockage d'énergie cinétique.

12. Procédé comprenant les étapes ci-dessous consistant à :
exploiter des ressources informatiques (104) au sein de zones de ressources (102) d'un centre de données (100) ;
fournir une puissance de fonctionnement aux ressources informatiques (104) à partir de systèmes d'alimentation sans coupure (106) associés respectivement aux zones de ressources (102), dans lequel une source d'alimentation secteur en courant alternatif alimente les systèmes d'alimentation sans coupure (106), et dans lequel une source d'alimentation en courant continu fournit temporairement de la puissance suite à une défaillance de la source d'alimentation secteur en courant alternatif ;
fournir une puissance temporaire à un système d'alimentation sans coupure (106) des systèmes d'alimentation sans coupure (106) à partir d'un premier élément de stockage d'énergie (108) d'un ou plusieurs éléments de stockage d'énergie (108), le premier élément de stockage d'énergie faisant partie du système d'alimentation sans coupure (106) ;
fournir une puissance temporaire supplémentaire au système d'alimentation sans coupure (106) à partir d'un élément de stockage d'énergie supplémentaire (202) situé à un emplacement distinct à l'extérieur des zones de ressources (102), dans lequel l'élément de stockage d'énergie supplémentaire (202) n'est pas colocalisé avec ou directement associé à des systèmes d'alimentation sans coupure correspondants (106) ; et
partager une puissance temporaire supplémentaire avec le système d'alimentation sans coupure (106) à partir d'un second élément de stockage d'énergie (108) dudit un ou desdits plusieurs éléments de stockage d'énergie (108), le second élément de stockage d'énergie ne faisant pas partie du système d'alimentation sans coupure (106).

13. Procédé selon la revendication 12, dans lequel ledit un ou lesdits plusieurs éléments de stockage d'énergie (108) incluent au moins un élément de stockage d'énergie (108) qui est situé au niveau d'une zone correspondante des zones de ressources (102), ou dans lequel ledit un ou lesdits plusieurs éléments de stockage d'énergie (108) incluent au moins un élément de stockage d'énergie (108) situé au niveau de chacune des zones de ressources (102), ou dans lequel ledit un ou lesdits plusieurs éléments de stockage d'énergie (108) incluent au moins un dispositif de stockage d'énergie cinétique qui est associé à chacune des zones de ressources (102), et au moins un dispositif de stockage d'énergie chimique qui est associé à une pluralité de zones de ressources (102).

14. Procédé selon la revendication 12 ou 13, dans lequel :
l'étape de partage de la puissance temporaire supplémentaire comprend l'étape consistant à diriger sélectivement la puissance temporaire fournie par le second élément de stockage d'énergie (108) vers le système d'alimentation sans coupure (106), en réponse à une diminution de puissance dudit premier élément de stockage d'énergie (108).

15. Procédé selon l'une quelconque des revendications 12 à 14, dans lequel :
l'étape de partage de la puissance temporaire supplémentaire comprend l'étape consistant à diriger sélectivement la puissance temporaire fournie par le second élément de stockage d'énergie (108) vers le système d'alimentation sans coupure (106), en réponse à un dysfonctionnement détecté dudit premier élément de stockage d'énergie (108).
